# EUROPEAN PATENT APPLICATION

(11) **EP 0 773 479 A1**
(43) Date of publication of application: **14.05.1997**
(21) Application number: 96117873.8
(22) Date of filing: 07.11.1996
(51) Int. Cl.: G03F 7/038, G03F 7/20, G03F 1/14

(54) **Method of polymer conversion and patterning of a PPV derivative**

(30) Priority: 13.11.1995 US 557404
(71) Applicant: MOTOROLA, INC., Schaumburg, IL 60196 (US)
(72) Inventor: Rogers, Stephen, Phoenix, Arizona 85048 (US); Nordquist, Kevin J., Gilbert, Arizona 85234 (US)
(74) Representative: Hudson, Peter David

(57) **Abstract**

A method of converting and patterning a precursor of a PPV derivative including forming a layer (132) of a soluble precursor of a PPV derivative, irradiating portions of the layer (132) in a desired pattern with accelerated electrons, using an electron beam exposure system, to convert irradiated portions of the layer (132) to a conjugated polymer of the PPV derivative, and removing unconverted portions of the layer (132) with a solvent, such as methanol, of the soluble precursor of the PPV derivative.

## Description

### Field of the Invention

This invention is related to a class of organic polymeric materials for use in optoelectronic devices such as light emitting diodes, more specifically the invention is related to poly(phenylene vinylene) derivatives and a new method of conversion and patterning.

### Background of the Invention

Poly(phenylene vinylene) and derivatives thereof, (hereinafter 'PPV derivatives'), one of the most studied polymers for light emitting device applications, are presently used in light emitting devices (LED) as a hole transporting material. PPV has outstanding chemical and thermal stability up to 400°C and is presently used in the fabrication of polymeric LEDs via a soluble non-conjugated precursor route. Films are cast from a methanolic solution of the precursor and then converted to a PPV derivative at 260°C in forming gas with the subsequent elimination of HCl and tetrahydrothiophene. However, one major problem in the prior art PPV used in light emitting devices is the intractability of the conjugated polymer of the PPV derivatives.

In a copending U.S. Patent Application entitled "Soluble Precursor to Poly(cyanoterephtyalydene) and Method of Preparation", serial number 08/322,501, filed on October 11, 1994 and assigned to the same assignee, a novel method of converting PPV precursors is disclosed. This method still requires somewhat complicated preparation and processing steps and requires extra patterning steps.

Therefore the challenge is to improve the methods of converting and patterning the PPV derivatives so that polymer light emitting devices can be practically manufactured.

It is a purpose of this invention to provide a new method for the conversion and patterning of PPV derivatives.

It is another purpose of this invention to provide a method for processing precursors to PPV derivatives for use in light emitting devices.

It is another purpose of this invention to provide a method for processing precursors to PPV derivatives for use as a negative photoresist.

It is another purpose of this invention to provide a PPV derivative as a directly exposed photomask masking material.

### Summary of the Invention

The above described problems and others are substantially solved and the above purposes and others are realized in a method of converting and patterning a precursor of a PPV derivative including the initial step of forming a layer of a soluble precursor of a PPV derivative. Using an electron beam exposure system, portions of the layer are irradiated in a desired pattern with accelerated electrons, to convert irradiated portions of the layer to a conjugated polymer of the PPV derivative. Unconverted portions of the layer are removed with a solvent, such as methanol, of the soluble precursor of the PPV derivative.

The above described problems and others are substantially solved and the above purposes and others are further realized in a method of fabricating an organic light emitting device including the steps of forming a first conductive layer having a first type of conductivity on the planar surface of a substrate, supporting a layer of a soluble precursor of a PPV derivative on the first conductive layer, irradiating portions of the layer in a desired pattern with accelerated electrons to convert irradiated portions of the layer to a conjugated polymer of the PPV derivative, removing unconverted portions of the layer with a solvent of the soluble precursor of PPV derivative, and positioning a second conductive layer having a second type of conductivity on the irradiated portions of the layer of PPV derivative material.

### Brief Description of the Drawings

### Referring to the drawings:

FIG. 1 is a graph illustrating film thickness of conjugated PPV polymer versus electron accelerating potentials and dosage;
FIG. 2 is a simplified cross-sectional view of a light emitting device using the conjugated PPV polymer in accordance with the present invention;
FIGS. 3 - 8 illustrate various sequential steps in an existing photomask process; and
FIGS. 9 - 11 illustrate sequential steps in a photomask process in accordance with the present invention.

### Description of the Preferred Embodiments

Poly(phenylene vinylene) (PPV) and its derivative are generally synthesized from a sulfonium salt precursor polymer (2) by a thermal or ultra violet (UV) radiation treatment. The precursor polymer (2) is in turn prepared by polymerization of arylene-p-bis(methylene sulfonium halide) (1) with a base such as sodium hydroxide, in a reaction such as that illustrated below (including the designating numbers).

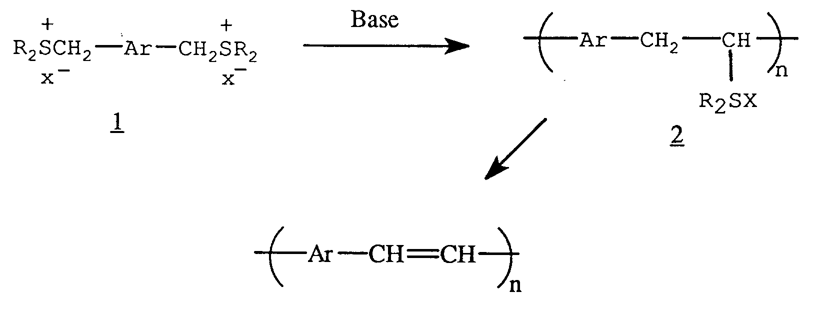

Since PPV is an intractable polymer, in the prior art long alkoxyl groups are incorporated into the backbone in order to achieve the needed solubility in organic solvents. However, along with the gain in solubility, those alkoxy groups also alter the electronic structure of PPV and, more specifically, the HOMO and LUMO energy levels of PPV or band gap width. As a result, the emission of the dialkoxy PPV is shifted, with respect to PPV, to the deep red region which is far less sensitive to the human eye. It would clearly be advantageous to acquire the needed processability without disturbing the electronic structure of PPV, so that the light emission falls in the desirable region for display purposes.

The strategy disclosed herein is an improved method of the conversion of the precursor polymer to a conjugated polymer and simultaneous patterning of the precursor polymer. The advantage of this method is that the precursor polymer can be patterned into any desired physical shape with simultaneous partial or complete conversion to the final conjugated polymer. Therefore, it is possible to make use of prior known polymers that are otherwise not processable for practical applications.

The present method of converting and patterning a precursor of a PPV derivative includes the step of forming a layer of a soluble precursor of a PPV derivative, generally in a prepolymer and methanol solution, on a desired surface by any convenient method, such as spin coating or the like. While this coating can be virtually any desired thickness and may vary for different applications, it is preferably in a range of 100 to 400 angstroms for light emitting diode (LED) applications. It may be thicker for other applications, such as use as a 1000 angstrom to 5000 angstrom resist mask for other semiconductor processing operations, e.g. doping, etching, sputtering metal, etc.; and, as a directly exposed 3000 angstrom to 5000 angstrom masking material on quartz photomask reticles or the like.

The PPV derivative layer is then irradiated with accelerated electrons, generally from an electron beam exposure system, commonly referred to as an E-beam. The electron irradiation eliminates the tetrahydrothiophene and HCl from the prepolymer in precise defined patterns. Thus, portions of the layer in the desired pattern which are irradiated with accelerated electrons are converted to a conjugated polymer of the PPV derivative. Generally, for the range of thicknesses of the PPV derivative layer disclosed above, the accelerating potential for the E-beam is in a range of 500 eV to 100 keV and the charge densities, or dosage, is in a range of 1 to 500 µC/cm².

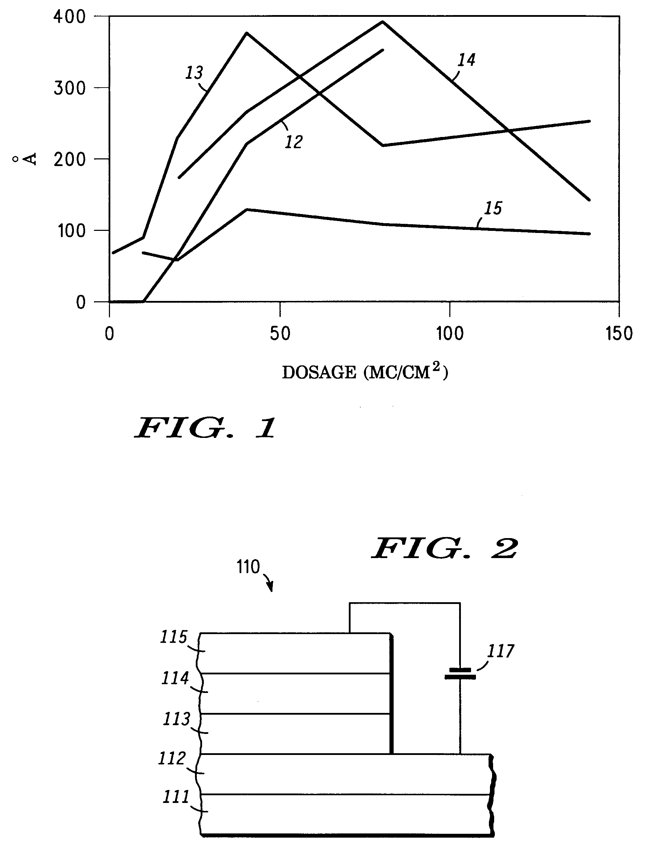

A graph of the film thickness of conjugated PPV polymer as a result of various accelerating potentials and dosages is illustrated in FIG. 1. A first line, designated 12, is the results of a 5 keV accelerating potential for various dosages, resulting in various layer thicknesses. Similarly, a line designated 13 is the results of a 10 keV accelerating potential, a line designated 14 is the results of a 20 keV accelerating potential, and a line designated 15 is the results of a 40 keV accelerating potential.

After the soluble precursor layer is irradiated in a beam of accelerated electrons, the unconverted portion of the precursor layer is removed with a solvent of the soluble precursor, such as methanol, or other solvents for other precursor materials.

In a specific example, a 2 inch square glass plate coated with a 2000 angstrom thick layer of indium-tin-oxide (ITO) was provided. A 300 - 400 angstrom thick layer of prepolymer poly-(p-phenylene vinylene) and methanol solution was spin coated on the surface of the ITO. The plate was then exposed in the E-beam within the above parameters using a Gaussian shaped beam of 120nm diameter and a beam current of 2nA. After exposure, the plate was immediately submerged in a container of methanol for 20 seconds and dried with N₂ gas. A plurality of different samples were formed using this technique and, while all of the samples fluoresced under a UV light, it was found that the conditions which produced the best results as far as fluorescing is concerned were: 10keV - 40, 80 and 140 µC/cm²; 20 keV - 20 40, 80 and 140 µC/cm²; and 5keV - 40 and 80 µC/cm².

Referring specifically to FIG. 2, a light emitting device (LED) 110 is illustrated in a simplified cross-sectional view. Generally, LED 110 includes a substrate 111 which in this specific embodiment is a glass plate having a relatively planar upper surface. An electrically conductive layer 112 is deposited on the planar surface of substrate 111 so as to form a relatively uniform electrical contact. In applications where substrate 111 is a transparent material, conductive layer 112 is usually transparent also and may be any convenient material, such as indium-tin-oxide (ITO). A layer 113 of, for example, PPV derivative hole transporting material obtained by the present method is deposited on the surface of conductive layer 112. A layer 114 is deposited onto the surface of layer 113. Layer 114 is a fluorescent electron transporting material, and in some instances, such as this embodiment, a PPV derivative is the fluorescent electron transporting material used in the formation of layer 114. Then a second electrically conductive layer 115 is deposited on the upper surface of layer 114 to form a second electrical contact.

In this embodiment, because layer 113 and layer 114 are composed of a PPV derivative obtained by the present precursor method, electrically conductive layer 115 can be formed of a relatively high work function metal, which in this specific embodiment is aluminum. The ability to use aluminum rather than some of the more exotic low work function metals, such as cesium, etc., greatly simplifies the device fabrication process. However, those knowledgeable in the art will recognize that layer 114 can be composed of organic and organometallic fluorescent electron transporting materials, such as 2-(4-biphenylyl)-5-phenyl-1,3,4-oxadiazole (PBD), and the like, bis-(10-hydroxybenzo{h}quinolinato)beryllium (Bebq), aluminum tris-8-hydroxyquinoline (Alq), and the like, and fluorescent dye doped electron transporting materials, which may require the more exotic low work function metals.

While it should be understood that light generated within layer 114 can be emitted either through layers 113, 112 and substrate 111 or through layer 115, in the present embodiment conductive layer 112 is formed of organic or inorganic conductors, such as conductive polyaniline (PANI), indium-tin-oxide (ITO), etc., which are substantially transparent to visible light so that the emitted light exits downwardly through substrate 111 in the figure.

Also, in the figure, LED 110 has a potential applied between layers 112 and 115 by means of a potential source 117. In this embodiment electrically conductive layer 112 is a p-type contact and electrically conductive layer 115 is an n-type contact. The negative terminal of potential source 117 is connected to electrically conductive layer 115 and the positive terminal is connected to electrically conductive layer 112. Electrons are injected from the n-type contact into fluorescent electron transporting layer 114 and holes injected from the p-type contact are transported through PPV derivative layer 113 and into fluorescent electron transporting layer 114 where, upon an electron and a hole recombination, a photon is emitted.

Thus, a new and improved method of converting soluble precursor PPV derivatives into conjugated polymers of the PPV derivatives is disclosed. Also, the method of converting the soluble precursors of the PPV derivatives can easily incorporate patterning so that polymer containing light emitting devices can be practically manufactured. Utilizing E-beam systems as a source of accelerated electrons, for example, allows patterns to be traced by the E-beam system so that true fine line patterning can be achieved to allow for simpler fabrication of polymer containing electroluminescent devices, for example. Further, the new and improved method eliminates etch processes and can eliminate masking to greatly simplify fabrication techniques.

Because large unconverted quantities of the precursor are simply washed away by a solvent in the removal step, the conversion by-products of HCl and tetrahydrothiophene are minimized. Also, the vacuum conditions of the E-beam system further enhances the elimination of these by-products from competing reverse chemical reactions, forcing a greater conversion of the precursor to the polymer. These benefits, along with the elimination of etch processes, minimizes defect generation in the devices being fabricated.

Because the conjugated polymers of the poly(phenylene vinylene) derivatives have high thermal stability (>400°C) and excellent chemical stability, the present novel method and product may have applications as a negative photoresist and a directly exposed masking material for photomasks. It is anticipated that photoresist and photomask applications may need thicker starting films, on the order of 1000 angstroms to 5000 angstroms, and more uniform coatings of the films.

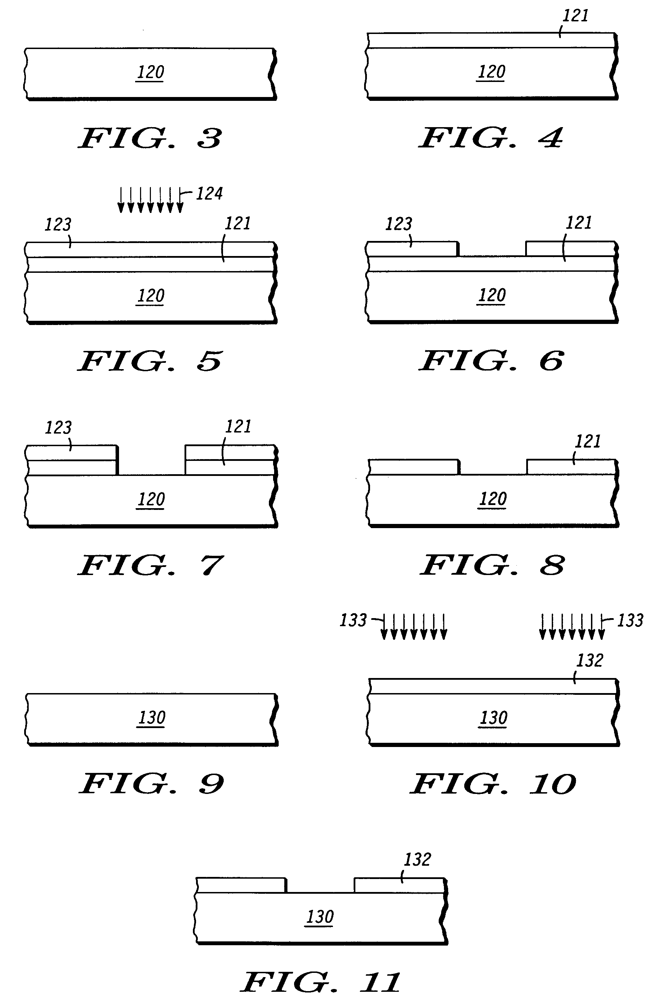

Referring specifically to FIGS. 3 - 8, a series of steps are illustrated in an existing photomask process. The existing photomask process generally starts with a quartz substrate 120 (FIG. 3), typically with a thickness on the order of 90 to 250 mil. A 3000 angstrom anti-reflective chrome layer 121 is sputtered on the top side of substrate 120, as illustrated in FIG. 4. Layer 121 is used as photon radiation masking material for subsequent process steps. Chrome masking layer 121 is patterned by first applying a 4000 angstrom coating 123 of photoresist, as illustrated in FIG. 5. Portions of coating 123 to be removed are then exposed to a suitable electron beam (indicated as arrows 124) and coating 123 is developed in a suitable solvent to provide the resist image produced by the electron beam exposure, as illustrated in FIG. 6. The resist pattern of coating 123 is then transferred to chrome layer 121 by wet etching chrome layer 121 in the exposed areas, as illustrated in FIG. 7. Coating 123 is then stripped off and the resulting photomask, illustrated in FIG. 8, is used for image transfer during semiconductor processing.

The photomasking process explained above is substantially simplified by utilizing the present inventive material and process. As illustrated in FIG. 9, the present process begins with a substrate 130, similar to the process explained above. A PPV precursor film 132 is then coated on the surface of substrate 130, as illustrated in FIG. 10, to a thickness in the range of approximately 3000 angstroms to 5000 angstroms. Film 132 is patterned by exposing it directly to an electron beam, represented by arrows 133 in FIG. 10, in a negative resist type of process. The regions of unexposed PPV precursor film 132 are dissolved and carried away in a 20 second submersion in a solvent, such as methanol, or the like. Due to its intractability, the remaining patterned portion of film 132 (which are converted PPV) is used as the photon radiation masking material with no further processing steps required.

Thus, a novel method for processing precursors to PPV derivatives for use as a negative photoresist is disclosed which substantially simplifies masking processes. Also, a PPV derivative is disclosed which is used as a directly exposed photomask masking material.

While we have shown and described specific embodiments of the present invention, further modifications and improvements will occur to those skilled in the art. We desire it to be understood, therefore, that this invention is not limited to the particular forms shown and we intend in the appended claims to cover all modifications that do not depart from the spirit and scope of this invention.

## Claims

1. A method of converting and patterning a precursor of a poly(phenylene vinylene) derivative characterized by the steps of:
forming a layer (132) of a soluble precursor of a poly(phenylene vinylene) derivative;
irradiating (133) portions of the layer (132) in a desired pattern with accelerated electrons to convert irradiated portions of the layer (132) to a conjugated polymer of the poly(phenylene vinylene) derivative; and
removing unconverted portions of the layer (132) with a solvent of the soluble precursor of poly(phenylene vinylene) derivative.

2. A method of converting and patterning a precursor of a poly(phenylene vinylene) derivative as claimed in claim 1 wherein the step of irradiating portions of the layer is further characterized by using an electron beam exposure system.

3. A method of converting and patterning a precursor of a poly(phenylene vinylene) derivative as claimed in claim 2 wherein the step of using an electron beam exposure system is further characterized by using the system at an accelerating potential in a range of 500 eV to 100 keV.

4. A method of converting and patterning a precursor of a poly(phenylene vinylene) derivative as claimed in claim 3 wherein the step of using an electron beam exposure system is further characterized by using the system at an accelerating potential in a preferred range of 5 keV to 20 keV.

5. A method of converting and patterning a precursor of a poly(phenylene vinylene) derivative as claimed in claim 3 wherein the step of using an electron beam exposure system is further characterized by using the system with a charge density in a range of 1 µC/cm² to 500 µC/cm².

6. A method of converting and patterning a precursor of a poly(phenylene vinylene) derivative as claimed in claim 5 wherein the step of using an electron beam exposure system is further characterized by using the system with a charge density in a preferred range of 40 µC/cm² to 80 µC/cm².

7. A method of converting and patterning a precursor of a poly(phenylene vinylene) derivative as claimed in claim 1 wherein the step of removing unconverted portions of the layer with the solvent is further characterized by using methanol as the solvent.

8. A method of converting and patterning a precursor of a poly(phenylene vinylene) derivative as claimed in claim 1 wherein the step of forming the layer of a soluble precursor of a poly(phenylene vinylene) derivative is further characterized by forming the layer (132) to a thickness in the range of 100 angstroms to 400 angstroms.

9. A method of fabricating an organic light emitting device characterized by the steps of:
providing a substrate (111) with a substantially planar surface;
forming a first conductive layer (112) having a first type of conductivity on the planar surface of the substrate (111);
supporting a layer (113, 114) of a soluble precursor of a poly(phenylene vinylene) derivative on the first conductive layer (112);
irradiating portions of the layer (113, 114) in a desired pattern with accelerated electrons to convert irradiated portions of the layer (113, 114) to a conjugated polymer of the poly(phenylene vinylene) derivative;
removing unconverted portions of the layer (113, 114) with a solvent of the soluble precursor of poly(phenylene vinylene) derivative; and
positioning a second conductive layer (115) having a second type of conductivity on the irradiated portions of the layer (113, 114) of poly(phenylene vinylene) derivative material.

10. A method of fabricating a photomask characterized by the steps of:
providing a substrate (130) with a substantially planar surface;
depositing a layer (132) of a soluble precursor of a poly(phenylene vinylene) derivative on the surface of the substrate (130);
irradiating portions of the layer (132) in a desired pattern with accelerated electrons to convert irradiated portions of the layer (132) to a conjugated polymer of the poly(phenylene vinylene) derivative; and
removing unconverted portions of the layer (132) with a solvent of the soluble precursor of poly(phenylene vinylene) derivative.
